# EUROPÄISCHE PATENTSCHRIFT

(11) **EP 3 208 925 B1**
(45) Veröffentlichungstag und Bekanntmachung des Hinweises auf die Patenterteilung: **12.09.2018**
(21) Anmeldenummer: 16156055.2
(22) Anmeldetag: 17.02.2016
(51) Int. Cl.: H02M 7/00

(54) **UMRICHTER**
CONVERTER
CONVERTISSEUR

(43) Veröffentlichungstag der Anmeldung: 23.08.2017
(73) Patentinhaber: Siemens Aktiengesellschaft, 80333 München (DE)
(72) Erfinder: SCHULZ, Martin, 80689 München (DE)

(56) Entgegenhaltungen:
- WO-A1-2013/000512
- WO-A1-2015/003734
- US-A- 6 028 779

## Beschreibung

Die Erfindung betrifft einen Umrichter zur Umwandlung einer zwischen zwei Eingangsanschlüssen anliegenden Eingangsspannung in eine Wechselspannung mit vorbestimmter Amplitude und Frequenz für die Ansteuerung einer ein- oder mehrphasigen Last, mit zumindest zwei seriell miteinander verschalteten Submodulen eines Inverterarms (siehe z.B. WO2015/003734).

Moderne modulare Umrichtertopologien mit Multilevel-Charakteristik bestehen aus identisch aufgebauten Funktionseinheiten, die als Submodule bezeichnet werden und entweder als Halbbrücken- oder Vollbrücken-Submodule aufgebaut sind. Diese werden zur Bereitstellung einer Inverterphase miteinander in Serie geschaltet. Die Verschaltung einer Vielzahl von Halbbrücken-Submodulen in Serie nimmt viel Bauraum ein. Dies sorgt für hohe Kosten des Umrichters.
Im Niederspannungsbereich ist es üblich, modulare Topologien aus, im Allgemeinen Leiterplatten-basierten, Submodule mit diskreten Leistungshalbleiterschaltelementen aufzubauen. Durch die Nutzung von Leiterplatten ergeben sich weitere Probleme durch die begrenzte Stromtragfähigkeit der Leiterplatten und den, im Vergleich zu Leistungsmodulen, bei denen die Leistungshalbleiterschaltelemente direkt auf einen Träger aufgebracht werden (sog. Direct Copper Bonding (DCB)), schlechteren Kühlbedingungen. In den Verbindungskabeln und den Kontaktstellen zwischen Verbindungskabeln und Leiterplatten entstehen erhebliche Stromwärmeverluste, welche abgeführt werden müssen.
Die elektrische Verbindung zwischen den diskreten Leistungshalbleiterschaltelementen und den Schraub- oder Klemmkontakten der Kabel wird über Kupferbahnen auf den Schaltungsträgern realisiert. Damit die benötigte Stromtragfähigkeit gewährleistet werden kann, kommen teure Hochstromschaltungsträger zum Einsatz. Diese sind als Dickkupfer-Platinen oder Platinen mit eingelegten Kupferprofilen bekannt.

Die Entwärmung bei einem Leiterplatten-basierten Umrichter erfolgt direkt an einem Hauptanschluss (in der Regel dem Drain- oder Kollektoranschluss des Leistungshalbleiterschaltelements). Dazu wird das Leistungshalbleiterschaltelement direkt mit seinem großflächigen Anschlusskontakt an einen Kühlkörper gepresst. Um eine elektrische Verbindung zwischen dem Anschlusskontakt und dem Kühlkörper zu vermeiden, ist zwischen diesen beiden Flächen ein Isolator angeordnet.

Die Stromwärmeverluste in den Verbindungskabeln und in den Kontaktstellen können dadurch minimiert und abgeführt werden, indem größere Kabelquerschnitte und größere Kontakte verwendet werden. Dies führt jedoch wiederum dazu, dass die Aufbau- und Verbindungstechnik sehr groß und schwer ausfällt.

Die Leiterplatten basierte Realisierung eines Umrichters wird gegenüber DCB-basierten Umrichtern dennoch häufig bevorzugt, da ein solcher Umrichter bessere elektrische Eigenschaften aufweist.

Es ist daher Aufgabe der vorliegenden Erfindung, einen Umrichter anzugeben, der baulich und/oder funktional verbessert ist.

Diese Aufgabe wird durch einen Umrichter gemäß den Merkmalen des Patentanspruches 1 gelöst. Vorteilhafte Ausgestaltungen ergeben sich aus den abhängigen Patentansprüchen.

Es wird ein Umrichter zur Umwandlung einer zwischen zwei Eingangsanschlüssen anliegenden Eingangsspannung in eine Wechselspannung mit vorbestimmter Amplitude und Frequenz für die Ansteuerung einer ein- oder mehrphasigen Last vorgeschlagen, mit zumindest zwei seriell miteinander verschalteten Submodulen eines Inverterarms, wobei jedes Submodul folgendes umfasst: einen Schaltungsträger; zumindest zwei steuerbare Schaltelemente, die auf dem Schaltungsträger elektrisch miteinander verschaltet sind; einen ersten Submodulanschluss; einen zweiten Submodulanschluss. Erste Hauptanschlüsse der steuerbaren Schaltelemente der zumindest zwei Submodule sind thermisch an eine Kühlfläche eines Kühlkörpers angeschlossen. Der zweite Submodulanschluss eines ersten der zumindest zwei Submodule ist mit einem ersten Submodulanschluss eines zweiten der zumindest zwei Halbbrücken-Submodule verbunden.

Der Umrichter zeichnet sich dadurch aus, dass die Verbindung des zweiten Submodulanschlusses des ersten Submoduls mit dem ersten Submodulanschluss des zweiten Submoduls durch eine auf der Kühlfläche aufgebrachte leitfähige Schicht realisiert ist.

Hierdurch wird es ermöglicht, einen Umrichter bereitzustellen, bei dem die Submodule Leiterplatten basiert aufgebaut sind. Dadurch lassen sich gute elektrisch Eigenschaften der Submodule und insgesamt des Umrichters bereitstellen. Gleichzeitig wird durch die Anbindung der Submodulanschlüsse über eine auf die Kühlfläche aufgebrachte leitfähige Schicht eine gute Wärmeabfuhr der in den Halbleiterschaltelementen im Betrieb anfallenden Wärme ermöglicht. Insbesondere ermöglicht es dieser Aufbau, die elektrischen Kontakte direkt zu kühlen.

Durch eine ausschließliche Kontaktierung der Submodule über die ersten Hauptanschlüsse der zwei Schaltelemente kann die Serienschaltung der Submodule sehr kompakt aufgebaut werden. Insbesondere ist der Befestigungsaufwand minimiert. Weiterhin wird eine direkte Kühlung der elektrischen Kontakte und der leitfähigen Schicht realisiert.

Ein weiterer Vorteil besteht darin, dass auf dem Schaltungsträger der Submodule ein verringerter Stromfluss im Vergleich zu einem herkömmlichen Submodul auftritt, da der Strom direkt über die ersten Hauptanschlüsse der Schaltelemente abgenommen wird. Dadurch ergibt sich eine vorteilhafte geringere thermische Beanspruchung der Schaltungsträger.

Gemäß einer zweckmäßigen Ausgestaltung sind die ersten Hauptanschlüsse der Schaltelemente Flächenkontakte, die vollflächig auf die leitfähige Schicht aufgebracht werden. Dadurch wird nicht nur eine große Stromtragfähigkeit sichergestellt. Vielmehr kann auch über die ersten Hauptanschlüsse der Wärmetransfer der in den Schaltelementen erzeugten Wärme in Richtung der leitfähigen Schicht und des Kühlkörpers erfolgen. Zudem wird die Herstellbarkeit erleichtert, da die ersten Hauptanschlüsse auf einfache Weise über die leitfähige Schicht mit dem Kühlkörper verbunden werden können. Es ist zu betonen, dass hierbei handelsübliche diskrete Leistungshalbleiterschaltelemente als Schaltelemente der Submodule zum Einsatz kommen können.

Gemäß einer weiteren zweckmäßigen Ausgestaltung sind die ersten Hauptanschlüsse der Schaltelemente kraftschlüssig und/oder stoffschlüssig mit der leitfähigen Schicht verbunden. Hierdurch ist eine gute Stromtragfähigkeit zwischen den ersten Hauptanschlüssen von Schaltelementen benachbarter Submodule über die leitfähige Schicht sichergestellt. Gleichzeitig wird ein guter Wärmetransfer zu dem Kühlkörper gewährleistet.

Gemäß einer weiteren zweckmäßigen Ausgestaltung ist die leitfähige Schicht eine Metallschiene, die über die Isolationsschicht mit dem Kühlkörper verbunden ist.

Eine weitere zweckmäßige Ausgestaltung sieht vor, dass die elektrische Verbindung, d.h. der Knotenpunkt, zwischen dem zweiten Hauptanschluss des ersten Schaltelements und dem ersten Hauptanschluss des zweiten Schaltelements eines jeweiligen Submoduls über eine oder mehrere Leiterbahnen des Schaltungsträgers des Submoduls realisiert ist. Hierzu kann der Schaltungsträger beispielsweise sog. Dickleiterbahnen (d.h. Leiterbahndicken von größer als 400 µm) aufweisen.

Eine weitere Ausgestaltung sieht vor, dass zwischen den zwei Eingangsanschlüssen pro Phase zwei Inverterarme seriell verschaltet sind, wobei ein Knotenpunkt zwischen den zwei Inverterarmen mit einem Ausgangsanschluss einer Inverterphase gekoppelt ist. Insbesondere umfasst der Umrichter pro Inverterarm und Phase zumindest zwei Submodule.

Gemäß einer weiteren zweckmäßigen Ausgestaltung umfasst ein jeweiliges Submodul eine Halbbrücke mit zwei steuerbaren und seriell verschalteten Schaltelementen. Der erste Submodulanschluss ist elektrisch mit einem ersten Hauptanschluss eines ersten der zumindest zwei Schaltelemente (High-Side-Schaltelement) verbunden. Der zweite Submodulanschluss ist elektrisch mit einem Knotenpunkt eines zweiten Hauptanschlusses des ersten Schaltelements und einem ersten Hauptanschluss eines zweiten der zumindest zwei Schaltelemente (Low-Side-Schaltelement) verbunden.

Gemäß einer weiteren zweckmäßigen Ausgestaltung umfasst das Submodul eine Vollbrücke mit zwei parallel verschalteten Halbbrücken, wobei in einer ersten der Halbbrücken ein erstes und ein zweites Schaltelement in Serie verschaltet sind und in einer zweiten der Halbbrücken ein drittes und ein viertes Schaltelement in Serie verschaltet sind. Der erste Submodulanschluss ist elektrisch mit einem Knotenpunkt eines zweiten Hauptanschlusses des ersten Schaltelements und einem ersten Hauptanschluss des zweiten Schaltelements verbunden. Der zweite Submodulanschluss ist elektrisch mit einem Knotenpunkt eines zweiten Hauptanschlusses des dritten Schaltelements und einem ersten Hauptanschluss des vierten Schaltelements verbunden. Die ersten Hauptanschlüsse des ersten und dritten Schaltelements sind über eine weitere leitfähige Schicht auf der Kühlfläche elektrisch miteinander verbunden.

Bei dieser Variante ist es zweckmäßig, wenn die weitere leitfähige Schicht zwischen den leitfähigen Schichten des ersten und des zweiten Submodulanschlusses auf dem Kühlkörper angeordnet ist.

Die Erfindung wird nachfolgend näher anhand eines Ausführungsbeispiels in der Zeichnung erläutert. Es zeigen:
- Fig. 1: die serielle Verschaltung einer Anzahl von Submodulen zur Bereitstellung einer Inverterphase zwischen einem Eingangsanschluss und einem Ausgangsanschluss;
- Fig. 2: ein elektrisches Ersatzschaltbild eines Halbbrücken-Submoduls;
- Fig. 3: eine schematische Darstellung zweier an einem Kühlkörper angeordneter Halbbrücken-Submodule in einer herkömmlichen Aufbauvariante; und
- Fig. 4: eine schematische Darstellung mehrerer Halbbrücken-Submodule an einem Kühlkörper in einer erfindungsgemäßen Ausgestaltung.

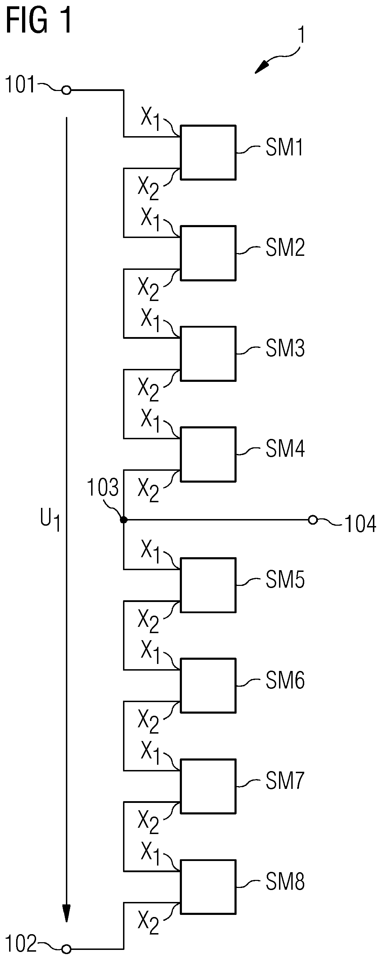

Fig. 1 zeigt eine Inverterphase eines Umrichters in sog. Multilevel-Topologie. Bei diesem sind zwischen einem Eingangsanschluss 101 und einem Eingangsanschluss 102 beispielhaft acht identisch aufgebaute Submodule SM1, ..., SM8 miteinander verschaltet. Ein Knotenpunkt 103 zwischen den Halbbrücken-Submodulen SM4 und SM5 ist mit einem Ausgangsanschluss 104 der Inverterphase verbunden. Die zwischen dem Eingangsanschluss 101 und dem Knotenpunkt 103 verschalteten Submodule SM1, ..., SM4 sind dabei einem oberen Inverterarm zugeordnet. Die zwischen dem Knotenpunkt 103 und dem Eingangsanschluss 102 seriell verschalteten Submodule SM1, ..., SM8 sind einem unteren Inverterarm zugeordnet. Zwischen den Eingangsanschlüssen 101 und 102 liegt eine Gleichspannung U₁ an. Die Eingangsanschlüsse 101, 102 sind Anschlüsse eines hier nicht näher dargestellten Gleichspannungszwischenkreises. Durch eine ebenfalls nicht dargestellte Steuerschaltung, die die in den jeweiligen Submodulen SM1, ..., SM8 enthaltenen Schaltelemente ansteuert und in geeigneter Weise leitend und sperrend schaltet, kann an dem Ausgangsanschluss 104 eine Wechselspannung abgegriffen werden.

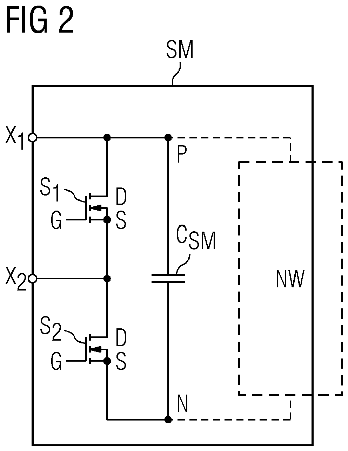

Fig. 2 zeigt ein elektrisches Ersatzschaltbild der identisch aufgebauten Submodule SM1, ..., SM8 in Gestalt eines Halbbrücken-Submoduls. So umfasst jedes der Halbbrücken-Submodule SM zwei seriell verschaltete Schaltelemente S₁, S₂. Bei den Schaltelementen S₁, S₂ handelt es sich beispielsweise um MOSFETs oder andere steuerbare Halbleiterschaltelemente. Der als Drain D bezeichnete erste Hauptanschluss des Schaltelements S₁ ist mit einem ersten Submodulanschluss X₁ verbunden. Der als Source S bezeichnete zweite Hauptanschluss des Schaltelements S₁ ist mit dem Drain-Anschluss D des zweiten Schaltelements S₂ verbunden. Der Knotenpunkt zwischen dem Source-Anschluss S des Schaltelements S₁ und dem Drain-Anschluss des Schaltelements S₂ bildet einen zweiten Submodulanschluss X₂. Der Source-Anschluss des zweiten Schaltelements S₂ ist über einen Kondensator C_{SM} mit dem Drain-Anschluss des ersten Schaltelements S₁ verbunden. Parallel zu dem Kondensator C_{SM} kann an die mit den Bezugszeichen P und N gekennzeichneten Knotenpunkte ein optionales Ausgangsnetzwerk NW angeschlossen sein.

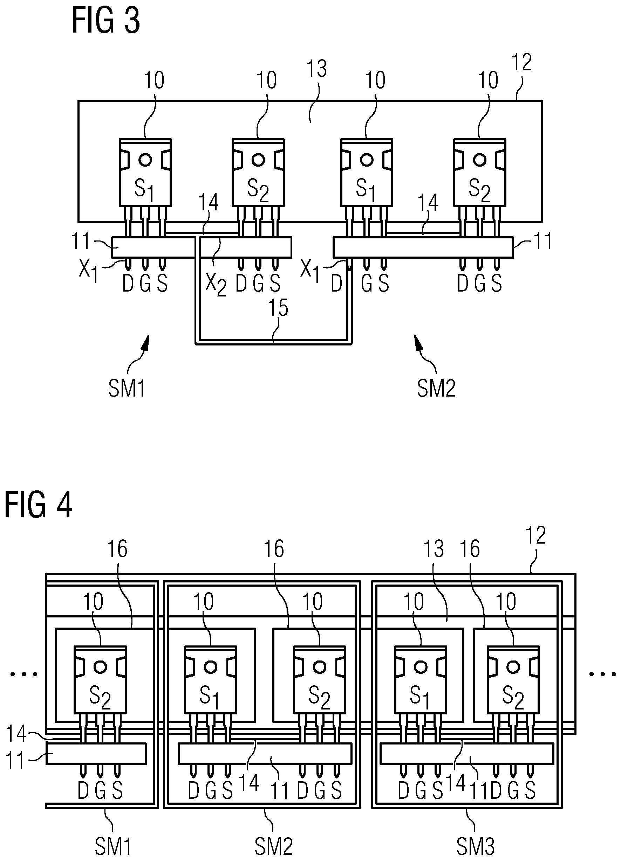

Zur Bereitstellung einer Inverterphase mit Multilevel-Charakteristik, wie diese in Fig. 1 dargestellt ist, werden die Submodulanschlüsse X₁, X₂ der jeweiligen Halbbrücken-Submodule in Serie miteinander verschaltet. So ist, wie dies Fig. 1 unschwer zu entnehmen ist, der erste Submodulanschluss X₁ des Submoduls SM1 mit dem Eingangsanschluss 101 verbunden. Der zweite Submodulanschluss X₂ des Submoduls SM1 ist mit dem ersten Submodulanschluss X₁ des Submoduls SM2 verbunden. Der zweite Submodulanschluss X₂ des Submoduls SM2 ist wiederum mit dem ersten Submodulanschluss des Submoduls SM3 verbunden, usw. Der zweite Submodulanschluss X₂ des Submoduls SM8 ist schließlich mit dem Eingangsanschluss 102 verbunden. Wie ebenfalls unschwer der Fig. 1 zu entnehmen ist, ist der Ausgangsanschluss 104 der Inverterphase des Umrichters 1 über den Knotenpunkt 103 sowohl mit dem zweiten Submodulanschluss X₂ des Submoduls SM4 als auch mit dem ersten Submodulanschluss X₁ des Submoduls SM5 verbunden.
Diese Verschaltung nimmt in dem Umrichter 1 viel Bauraum in Anspruch Fig. 3 zeigt eine mögliche Aufbauvariante für zwei benachbart auf einem Kühlkörper 12 angeordnete, Leiterplatten-basierte Submodule SM1, SM2. Bei dieser Aufbauvariante ist jedes Submodul SM1, SM2 unter Verwendung von diskreten Leistungshalbleiterschaltelementen und einem Schaltungsträger aufgebaut. Hierdurch ergeben sich im Vergleich zu dem aus dem Stand der Technik bekannten Direct Copper Bonding (DCB) bessere elektrische Eigenschaften.
Die Submodule SM1, SM2 (in entsprechender Weise gilt dies natürlich auch für die weiteren, in Fig. 3 nicht dargestellten Submodule SM3, ..., SM8) umfassen jeweils einen Schaltungsträger 11. Auf den Schaltungsträger 11 sind jeweils zwei Leistungshalbleiterschaltelemente 10 aufgebracht. Jedes der Leistungshalbleiterschaltelemente umfasst drei Kontaktpins, welche durch entsprechende, in Fig. 3 nicht näher dargestellte Öffnungen oder Bohrungen des Schaltungsträgers 11 gesteckt und verlötet sind. Die drei Kontaktpins stellen den Drain-Anschluss D (erster Hauptanschluss), den Source-Anschluss S (zweiter Hauptanschluss) und den Gate-Anschluss G (Steueranschluss) dar. Eine elektrische Verbindung zwischen dem Source-Anschluss des mit S₁ gekennzeichneten Leistungshalbleiterschaltelements 10 und dem Drain-Anschluss des mit S₂ gekennzeichneten Leistungshalbleiterschaltelements 10 erfolgt über eine Leiterbahn 14. Aufgrund des hohen fließenden Stromes kann hierbei die Leiterbahn 14 als Dickkupfer-Leiterbahn ausgebildet sein. Die elektrische Verbindung zwischen dem Source-Anschluss S von S₁ und dem Drain-Anschluss D von S₂ bildet den in Verbindung mit Fig. 2 erläuterten zweiten Submodulanschluss X₂. Der erste Submodulanschluss X₁ ist der Drain-Anschluss D des mit S₁ gekennzeichneten Leistungshalbleiterschaltelements 10.

Die Entwärmung der Leistungshalbleiterschaltelemente 10 erfolgt direkt an deren Drain-Anschlüssen D durch direktes Aufpressen der auf der Rückseite der diskreten Leistungshalbleiterschaltelemente 10 ausgebildeten Drain-Anschlüssen D an den bereits erwähnten Kühlkörper 12. Um einen Kurzschluss der Drain-Anschlüsse D über den Kühlkörper 12 zu vermeiden, ist auf der dem Betrachter zugewandten Seite des Kühlkörpers 12 eine gut wärmeleitende Isolationsschicht 13 aufgebracht. Um einen innigen Kontakt zwischen den Rückseitenkontakten (Drain-Anschlüsse) der Leistungshalbleiterschaltelemente 10 und dem Kühlkörper 12 sicherzustellen, können die Leistungshalbleiterschaltelemente z.B. auf den Kühlkörper 12 aufgeschraubt sein.

Zur Herstellung der elektrischen Verbindung zwischen dem zweiten Submodulanschluss X₂ des Submoduls SM1 und dem ersten Submodulanschluss X₁ des Submoduls SM2 wird bei der Anordnung gemäß Fig. 3 ein Kabel 15 genutzt. Dies wird beispielsweise zwischen entsprechenden Kontaktflächen der Schaltungsträger 11 elektrisch in der in Fig. 3 gezeigten Weise verschraubt. Aufgrund der an den Kontaktstellen auftretenden Stromwärmeverluste zwischen dem Kabel 15 und den betreffenden Schaltungsträgern 11 der Halbbrücken-Submodule SM1, SM2 werden große Kabelquerschnitte und große Kontakte verwendet. Dies führt jedoch dazu, dass die Aufbau- und Verbindungstechnik sehr groß und schwer ausfällt.

Fig. 4 zeigt eine erfindungsgemäße Aufbauvariante. In der Darstellung der Fig. 4 sind dabei das Schaltmodul SM1 teilweise sowie die seriell mit diesem verschalteten Schaltmodule SM2 und SM3 dargestellt. Die in Fig. 3 mit dem Bezugszeichen 15 gekennzeichnete elektrische Verbindung ist in der erfindungsgemäßen Aufbauvariante jeweils durch eine leitfähige Schicht 16 ersetzt, welche zwischen den diskreten Leistungshalbleiterschaltelementen 10 und der Isolationsschicht 13 auf dem Kühlkörper 12 angeordnet ist. Dabei sind der Drain-Anschluss des zweiten Schaltelements S₂ eines Halbbrücken-Submoduls (z.B. SM1) und der Drain-Anschluss des ersten Schaltelements S₁ des benachbarten Halbbrücken-Submoduls (SM2) auf der leitfähigen Schicht 16 aufgebracht und elektrisch leitend mit dieser verbunden. In entsprechender Weise ist der Drain-Anschluss des zweiten Schaltelements S₂ des Halbbrücken-Submoduls SM2 und der Drain-Anschluss D des ersten Schaltelements S₁ des benachbarten Halbbrücken-Submoduls (hier: SM3) auf einer anderen leitfähigen Schicht aufgebracht. Auf einer jeweiligen leitfähigen Schicht 16 sind somit jeweils paarweise die Drain-Anschlüsse der Schaltelemente benachbarter Halbbrücken-Submodule aufgebracht.

Durch die ausschließliche Kontaktierung der Drain-Anschlüsse D der Halbbrücken-Submodule SM der diskreten Leistungshalbleiterschaltelemente kann die Serienschaltung der Halbbrücken-Submodule sehr kompakt aufgebaut werden. Insbesondere ergibt sich eine kompakte Serienschaltung mit minimalem Befestigungsaufwand. Es ist eine direkte Kühlung der elektrischen Kontakte und der elektrischen Schichten möglich. Die elektrischen Schichten sind beispielsweise in Gestalt von Metallschienen realisiert.

Der Knotenpunkt bzw. Ausgangsanschluss lässt sich mit Hilfe der leitfähigen Schicht realisieren. So kann die leitfähige Schicht beispielsweise eine von den Schaltungsträgern weg weisende Lasche (nicht gezeigt) aufweisen, so dass im Flächenbereich der Lasche eine Verschraubung oder Steckverbindung zu dem Ausgangsanschluss erfolgen kann.

Es ergibt sich ein verringerter Stromfluss über den jeweiligen Schaltungsträger der Halbbrücken-Submodule, da ein Großteil des Stroms direkt an den Drain-Anschlüssen der Leistungshalbleiterschaltelemente abgenommen wird. Dadurch ergibt sich eine geringere thermische Beanspruchung der jeweiligen Schaltungsträger.

Ermöglicht wird die erfindungsgemäß vorgeschlagene Aufbauvariante dadurch, dass alle Kontaktierungsstellen (d.h. die Drain-Anschlüsse der Leistungshalbleiterschaltelemente) gleichzeitig diejenigen Stellen sind, an denen die Wärme der Leistungshalbleiterschaltelemente abgeführt wird. Dadurch erfolgt eine Aufhebung der bisherigen Trennung zwischen elektrischen und thermischen Pfaden. Vielmehr stimmen diese nunmehr überein.

Die Entwärmung der Halbleiterschaltelemente zum Kühlkörper 12 wird durch die elektrisch leitfähige Schicht 16 nur minimal beeinflusst, da diese mit einem sehr hohen thermischen Leitwert bereitgestellt werden können. Bevorzugt bestehen die leitfähigen Schichten 16 aus Kupfer oder Aluminium oder Legierungen davon.

In dem vorliegenden Ausführungsbeispiel wurde die Erfindung in den Figuren 2 bis 4 anhand von Halbbrücken-Submodulen einer Inverterphase beschrieben. Das erfindungsgemäße Prinzip lässt sich ohne weiteres auch auf Vollbrücken-Submodule übertragen. Ein Vollbrücken-Submodul umfasst vier Schaltelemente in zwei parallelen Pfaden, wobei je Pfad zwei der Schaltelemente seriell miteinander verschaltet sind. Bei einem solchen Vollbrücken-Submodul sind die Drain-Anschlüsse der beiden High-Side-Schaltelemente auf einer gemeinsamen elektrisch leitenden Schicht verschaltet. Die Low-Side-Schaltelemente sind demgegenüber mit Schaltelementen zweier jeweils benachbarter Vollbrücken-Submodule über eine leitfähige Schicht verbunden.

## Patentansprüche

1. Umrichter zur Umwandlung einer zwischen zwei Eingangsanschlüssen (101, 102) anliegenden Eingangsspannung (U₁) in eine Wechselspannung mit vorbestimmter Amplitude und Frequenz für die Ansteuerung einer ein- oder mehrphasigen Last, mit zumindest zwei seriell miteinander verschalteten Submodulen (SM; SM1,...,SM8) eines Inverterarms, wobei jedes Submodul (SM; SM1,...,SM8) folgendes umfasst:
- einen Schaltungsträger (11);
- zumindest zwei steuerbare Schaltelemente (S₁, S₂), die auf dem Schaltungsträger (11) elektrisch miteinander verschaltet sind;
- einen ersten Submodulanschluss (X₁) ;
- einen zweiten Submodulanschluss (X₂) ;
bei dem
- erste Hauptanschlüsse (D) der steuerbaren Schaltelemente (S₁, S₂) der zumindest zwei Submodule (SM; SM1,...,SM8) thermisch flächig an eine Kühlfläche eines Kühlkörpers (12) angeschlossen sind;
- der zweite Submodulanschluss (X₂) eines ersten der zumindest zwei Submodule (SM; SM1,...,SM8) mit dem ersten Submodulanschluss (X₁) eines zweiten der zumindest zwei Submodule (SM; SM1,...,SM8) verbunden ist;
**dadurch gekennzeichnet, dass**
die Verbindung des zweiten Submodulanschlusses (X₂) des ersten Submoduls (SM; SM2,...,SM8) mit dem ersten Submodulanschluss (X₁) des zweiten Submoduls (SM; SM1,...,SM7) durch eine auf der Kühlfläche aufgebrachte leitfähige Schicht (16) realisiert ist.

2. Umrichter nach Anspruch 1, **dadurch gekennzeichnet, dass** die ersten Hauptanschlüsse (D) der Schaltelemente (S₁, S₂) Flächenkontakte sind, die vollflächig auf die leitfähige Schicht (16) aufgebracht sind.

3. Umrichter nach Anspruch 1 oder 2, **dadurch gekennzeichnet, dass** die ersten Hauptanschlüsse (D) der Schaltelemente (S₁, S₂) kraftschlüssig und/oder stoffschlüssig mit der leitfähigen Schicht (16) verbunden sind.

4. Umrichter nach einem der vorhergehenden Ansprüche, **dadurch gekennzeichnet, dass** die leitfähige Schicht (16) eine Metallschiene ist, die über eine Isolationsschicht (13) mit dem Kühlkörper (12) verbunden ist.

5. Umrichter nach einem der vorhergehenden Ansprüche, **dadurch gekennzeichnet, dass** die elektrische Verbindung zwischen dem zweiten Hauptanschluss (S) des ersten Schaltelements (S₁) und dem ersten Hauptanschluss (D) des zweiten Schaltelements (S₂) eines jeweiligen Halbbrücken-Submoduls (SM; SM1,...,SM8) über eine oder mehrere Leiterbahnen des Schaltungsträgers (11) des Halbbrücken-Submoduls realisiert ist.

6. Umrichter nach einem der vorhergehenden Ansprüche, **dadurch gekennzeichnet, dass** zwischen den zwei Eingangsanschlüssen pro Phase zwei Inverterarme seriell verschaltet sind, wobei ein Knotenpunkt zwischen den zwei Inverterarmen mit einem Ausgangsanschluss einer Inverterphase gekoppelt ist.

7. Umrichter nach Anspruch 6, **dadurch gekennzeichnet, dass** dieser pro Inverterarm und Phase zumindest zwei Submodule (SM; SM1,...,SM8) umfasst.

8. Umrichter nach einem der Ansprüche 1 bis 7, **dadurch gekennzeichnet, dass**
- ein jeweiliges Submodul (SM; SM1,...,SM8) eine Halbbrücke mit zwei steuerbaren und seriell verschalteten Schaltelementen (S1, S2) umfasst;
- der erste Submodulanschluss (X1) elektrisch mit einem ersten Hauptanschluss (D) eines ersten der zumindest zwei Schaltelemente (S1, S2) verbunden ist;
- der zweite Submodulanschluss (X2) elektrisch mit einem Knotenpunkt eines zweiten Hauptanschlusses (S) des ersten Schaltelements (S1) und einem ersten Hauptanschluss (D) eines zweiten der zumindest zwei Schaltelemente (S2) verbunden ist.

9. Umrichter nach einem der Ansprüche 1 bis 7, **dadurch gekennzeichnet, dass**
- das Submodul (SM; SM1,...,SM8) eine Vollbrücke mit zwei parallel verschalteten Halbbrücken umfasst, wobei in einer ersten der Halbbrücken ein erstes und ein zweites Schaltelement in Serie verschaltet sind und in einer zweiten der Halbbrücken ein drittes und ein viertes Schaltelement in Serie verschaltet sind;
- der erste Submodulanschluss (X₁) elektrisch mit einem Knotenpunkt eines zweiten Hauptanschlusses (S) des ersten Schaltelements und einem ersten Hauptanschluss (D) des zweiten Schaltelements verbunden ist;
- der zweite Submodulanschluss (X₂) elektrisch mit einem Knotenpunkt eines zweiten Hauptanschlusses (S) des dritten Schaltelements und einem ersten Hauptanschluss (D) des vierten Schaltelements verbunden ist;
- die ersten Hauptanschlüsse (D) des ersten und dritten Schaltelements über eine weitere leitfähige Schicht auf der Kühlfläche elektrisch miteinander verbunden sind.

10. Umrichter nach Anspruch 9, **dadurch gekennzeichnet, dass** die weitere leitfähige Schicht zwischen den leitfähigen Schichten des ersten und des zweiten Submodulanschlusses (X₁, X₂) auf dem Kühlkörper angeordnet ist.

## Claims

1. Converter for converting an input voltage (U₁) applied between two input terminals (101, 102) into an alternating voltage with predetermined amplitude and frequency for controlling a single-phase or multi-phase load, with at least two series-connected submodules (SM; SM1,...,SM8) of an inverter arm, wherein each submodule (SM; SM1,...,SM8) comprises the following:
- a circuit carrier (11);
- at least two controllable switching elements (S₁, S₂) which are electrically connected to each other on the circuit carrier (11);
- a first submodule terminal (X₁) ;
- a second submodule terminal (X₂) ;
in which
- first main terminals (D) of the controllable switching elements (S₁, S₂) of the at least two submodules (SM; SM1,...,SM8) are thermally surface-connected to a cooling surface of a heat sink (12);
- the second submodule terminal (X₂) of a first of the at least two submodules (SM; SM1,...,SM8) is connected to the first submodule terminal (X₁) of a second of the at least two submodules (SM; SM1,..., SM8);
**characterised in that**
the connection of the second submodule terminal (X₂) of the first submodule (SM; SM1,...,SM8) to the first submodule terminal (X₁) of the second submodule (SM; SM1,...,SM7) is realised by a conductive layer (16) applied to the cooling surface.

2. Converter according to claim 1, **characterised in that** the first main terminals (D) of the switching elements (S₁, S₂) are surface contacts, which are applied over the entire surface of the conductive layer (16).

3. Converter according to claim 1 or 2, **characterised in that** the first main terminals (D) of the switching elements (S₁, S₂) are positively and/or materially connected to the conductive layer (16).

4. Converter according to one of the preceding claims, **characterised in that** the conductive layer (16) is a metal rail, which is connected to the heat sink (12) via an insulating layer (13).

5. Converter according to one of the preceding claims, **characterised in that** the electrical connection between the second main terminal (S) of the first switching element (S₁) and the first main terminal (D) of the second switching element (S₂) of a respective half-bridge submodule (SM; SM1,...,SM8) is realised via one or more conductive paths of the circuit carrier (11) of the half-bridge submodule.

6. Converter according to one of the preceding claims, **characterised in that** two inverter arms are series-connected between the two input terminals per phase, wherein a node is coupled between the two inverter arms to an output terminal of an inverter phase.

7. Converter according to claim 6, **characterised in that** the latter comprises at least two submodules (SM; SM1,...,SM8) per inverter arm and phase.

8. Converter according to one of claims 1 to 7, **characterised in that**
- a respective submodule (SM; SM1,...,SM8) comprises a half-bridge with two controllable and series-connected switching elements (S₁, S₂) ;
- the first submodule terminal (X1) is electrically connected to a first main terminal (D) of a first of the at least two switching elements (S₁, S₂) ;
- the second submodule terminal (X₂) is electrically connected to a node of a second main terminal (S) of the first switching element (S₁) and a first main terminal (D) of a second of the at least two switching elements (S₂).

9. Converter according to one of claims 1 to 7, **characterised in that**
- the submodule (SM; SM1,...,SM8) comprises a full-bridge with two parallel-connected half-bridges, wherein a first and a second switching element are series-connected in a first of the half-bridges and a third and a fourth switching element are series-connected in a second of the half-bridges;
- the first submodule terminal (X₁) is electrically connected to a node of a second main terminal (S) of the first switching element and a first main terminal (D) of the second switching element;
- the second submodule terminal (X₂) is electrically connected to a node of a second main terminal (S) of the third switching element and a first main terminal (D) of the fourth switching element;
- the first main terminals (D) of the first and third switching element are electrically connected to one another via a further conductive layer on the cooling surface.

10. Converter according to claim 9, **characterised in that** the further conductive layer is arranged between the conductive layers of the first and the second submodule terminal (X₁, X₂) on the heat sink.

## Revendications

1. Convertisseur de transformation d'une tension (U₁) d'entrée s'appliquant entre deux bornes (101, 102) d'entrée en une tension alternative d'une amplitude et fréquence déterminées à l'avance pour commander une charge monophasée ou polyphasée, comprenant au moins deux sous-modules (SM; SM1,..., SM8), montés en série entre eux, d'un bras d'inverseur, chaque sous-module (SM; SM1,..., SM8) comprenant ce qui suit :
- un support (11) de circuit;
- au moins deux éléments (S₁, S₂) de commutation, qui peuvent être commander et qui sont reliés électriquement entre eux sur le support (11) de circuit;
- une première borne (X₁) de sous-module;
- une deuxième borne (X₂) de sous-module;
dans lequel
- des premières bornes (D) principales des éléments (S₁, S₂) de commutation pouvant être commandés des au moins deux sous-modules (SM; SM1,..., SM8) sont raccordés suivant une surface thermiquement à une surface de refroidissement d'un dissipateur (12) de chaleur;
- la deuxième borne (X₂) d'un premier des au moins deux sous-modules (SM; SM1,..., SM8) est reliée à la première borne (X₁) d'un deuxième des au moins deux sous-modules (SM; SM1,..., SM8);
**caractérisé en ce que**
la liaison de la deuxième borne (X₂) du premier sous-module (SM; SM1,..., SM8) à la première borne (X₁) du deuxième sous-module (SM; SM1,..., SM7) est réalisée par une couche (16) conductrice déposée sur la surface de refroidissement.

2. Convertisseur suivant la revendication 1, **caractérisé en ce que** les premières bornes (D) principales des éléments (S₁, S₂) de commutation sont des contact en surface, qui sont déposés sur toute la surface sur la couche (16) conductrice.

3. Convertisseur suivant la revendication 1 ou 2, **caractérisé en ce que** les premières bornes (D) principales des éléments (S₁, S₂) de commutation sont reliées à coopération de force et/ou à coopération de matière à la couche (16) conductrice.

4. Convertisseur suivant l'une des revendications précédentes, **caractérisé en ce que** la couche (16) conductrice est une barre métallique, qui est reliée au dissipateur (12) de chaleur par une couche (13) isolante.

5. Convertisseur suivant l'une des revendications précédentes, **caractérisé en ce que** la liaison électrique, entre la deuxième borne (S) principale du premier élément (S1) de commutation et la première borne (D) principale du deuxième élément (S2) de commutation, d'un sous-module (SM; SM1,..., SM8) en demi-pont, est réalisée par l'intermédiaire d'une ou de plusieurs pistes conductrices du support (11) de circuit du sous-module en demi-pont.

6. Convertisseur suivant l'une des revendications précédentes, **caractérisé en ce que** deux bras d'inverseur sont montés en série, entre les deux bornes d'entrée par phase, un point nodal entre les deux bras d'inverseur étant couplé à une borne de sortie d'une phase d'inverseur.

7. Convertisseur suivant la revendication 6, **caractérisé en ce qu'**il comprend un bras d'inverseur et phase au moins deux sous-modules (SM; SM1,..., SM8).

8. Convertisseur suivant l'une des revendications 1 à 7, **caractérisé en ce que**
- un sous-module (SM; SM1,..., SM8) .comprend un demi-pont ayant deux éléments (S₁, S₂) de commutation pouvant être commandés et montés en série;
- la première borne (X₁) du sous-module est reliée électriquement à une première borne (D) principale d'un premier des au moins deux éléments (S₁, S₂) de commutation;
- la deuxième borne (X₂) du sous-module est reliée électriquement à un point nodal d'une deuxième borne (S) principale du premier élément (S₁) de commutation et a une première borne (D) principale d'un deuxième des au moins deux éléments (S₂) de commutation.

9. Convertisseur suivant l'une des revendications 1 à 7, **caractérisé en ce que**
- le sous-module (SM; SM1,..., SM8). comprend un pont complet ayant deux des demi-ponts montés en parallèle, dans lequel, dans un premier des demi-ponts, un premier et un deuxième éléments de commutation sont montés en série et dans un deuxième des demi-ponts, un troisième et quatrième éléments de commutation sont montés en série;
- la première borne (X₁) du sous-module est reliée électriquement à un point nodal de la deuxième borne (S) principale du premier élément de commutation et à une première borne (D) principale du deuxième élément de commutation;
- la deuxième borne (X₂) du sous-module est reliée électriquement à un point nodal d'une deuxième borne (S) principale du troisième élément de commutation et à une première borne (D) principale du quatrième élément de commutation;
- les premières bornes (D) principales du premier et du troisième éléments de commutation sont reliées entre elles électriquement par une autre couche conductrice sur la surface de refroidissement.

10. Convertisseur suivant la revendication 9, **caractérisé en ce que** l'autre couche conductrice est disposée entre les couches conductrices de la première et de la deuxième bornes (X₁, X₂) de sous-module sur le dissipateur de chaleur.
